# EUROPÄISCHE PATENTSCHRIFT

(11) **EP 1 223 670 B1**
(45) Veröffentlichungstag und Bekanntmachung des Hinweises auf die Patenterteilung: **28.09.2011**
(21) Anmeldenummer: 01129646.4
(22) Anmeldetag: 12.12.2001
(51) Int. Cl.: H03C 3/22

(54) **Spannungsgesteuerter Oszillator zur Frequenzmodulation**
Voltage controlled oscillator for frequency modulation
Oscillateur commandé en tension pour modulation de fréquence

(30) Priorität: 03.01.2001 DE 10100113
(43) Veröffentlichungstag der Anmeldung: 17.07.2002
(73) Patentinhaber: Infineon Technologies AG, 85579 Neubiberg (DE)
(72) Erfinder: Getta, Klaus, 44803 Bochum (DE); Grewing, Christian, 40489 Düsseldorf (DE); Matter, Udo, 40489 Düsseldorf (DE); Rassouli, Faramarz, San Diego, CA 92130 (US)
(74) Vertreter: Viering, Jentschura & Partner

(56) Entgegenhaltungen:
- DE-A- 4 241 241
- GB-A- 2 338 128
- US-A- 4 074 209
- US-A- 4 503 402
- US-A- 4 536 724
- US-A- 4 904 964

## Beschreibung

Die vorliegende Erfindung betrifft einen spannungsgesteuerten Oszillator (VCO, Voltage-Controlled Oscillator) zur Frequenzmodulation (FM, Frequency Modulation).

Die Frequenzmodulation ist eines der bekannten Modulationsverfahren, welche bei digitalen Modulationsverfahren angewendet werden. Derartige digitale Übertragungssysteme sind beispielsweise DECT (Digital Enhanced Cordless Telecommunication), welches bei Schnurlostelefonen eingesetzt wird oder BLUETOOTH, welches als Standard für eine Schnittstelle zur drahtlosen Kommunikation über kurze Entfernungen entworfen wurde.

Bei dem Frequenzmodulationsverfahren wird die zu übertragende, digital codierte Information auf einen Träger, beispielsweise eine Sinusschwingung mit hoher Frequenz, aufmoduliert. Die beschriebenen Standards legen in ihren Spezifikationen Grenzwerte für den Modulationshub fest. Der Modulationshub ist dabei die Hälfte der Frequenzdifferenz zwischen derjenigen Frequenz, mit der eine digitale Null, und derjenigen Frequenz, mit der eine digitale Eins codiert wird, wenn die zu übertragende Information binär codiert ist. Die Grenzwerte für den Modulationshub dürfen weder über- noch unterschritten werden.

Hochintegrierte, spannungsgesteuerte Oszillatoren, welche in Phasenregelschleifen einsetzbar sind, wie sie in Sendern für derartige Mobilfunksysteme benötigt werden, sind üblicherweise toleranzbehaftet, da die frequenzbestimmenden integrierten Bauteile Fertigungstoleranzen unterliegen. VCOs können beispielsweise als LC-Oszillator ausgeführt sein, bei denen die Schwingfrequenz bei einer bestimmten Abstimmspannung durch Toleranzen der Bauelemente, insbesondere Induktivität und Kapazität, beeinflußt wird. Um dennoch einen Abstimmbereich in einem Normalbetrieb zu erzielen, welcher beispielsweise 100 MHz beträgt, ist es üblich, beim Schaltungsentwurf des VCO dessen Abstimmbereich größer auszulegen, beispielsweise auf 600 MHz, wenn der absolute Frequenzbereich bei ca. 2,5 GHz liegt. Der Abstimmbereich ist dabei der Bereich eines Ausgangssignals des VCO, welcher zwischen einer minimal abstimmbaren Frequenz und einer maximal abstimmbaren Frequenz liegt.

Derartig große Abstimmbereiche oder Tuningbereiche führen jedoch beispielsweise bei LC-Oszillatoren mit fester Induktivität dazu, daß die Kapazität im Resonanzkreis in einem breiten Abstimmbereich variierbar sein muß. Hierdurch ergibt sich jedoch das Problem, daß beispielsweise bei Verwendung einer verstellbaren Modulationskapazität kein konstanter Modulationshub über den gesamten abstimmbaren Frequenzbereich erzielbar ist, sondern daß sich vielmehr der Modulationshub über den abstimmbaren Bereich hinweg stark ändert und dabei Grenzwerte der Spezifikationen verletzt.

Die Problematik soll an einem Zahlenbeispiel verdeutlicht werden: Ein VCO mit LC-Resonator hat eine Induktivität mit einem festen Induktivitätswert von 2 nH. Um einen Abstimmbereich oder Tuningbereich von 2,2 - 2,8 GHz zu erzielen, muß die im Resonator wirksame Kapazität von 1,62 - 2,62 pF verstellbar sein. An der unteren Grenze des Abstimmbereiches, bei 2,2 GHz, ist für einen Modulationshub von 160 KHz, wie er bei BLUETOOTH gefordert ist, eine Modulationskapazität von 0,38 fF (Femtofarad) erforderlich. Die gleiche Modulationskapazität an der oberen Abstimmgrenze von 2,8 GHz bewirkt jedoch einen Modulationshub von 328 KHz, welcher über dem spezifizierten Grenzwert liegt.

Es ist bereits bekannt, bei spannungsgesteuerten Oszillatoren einen Abgleich des festen Induktivitätswertes des VCO dadurch zu erzielen, daß in einem Abgleichschritt während der Fertigung eine Spule mit einem zu großen Induktivitätswert in geeigneter Weise verkleinert wird. Ein derartiger Abgleich ist jedoch sowohl kosten- als auch zeitintensiv. Ein derartiger Abgleich kann beispielsweise unter Verwendung eines Lasers erfolgen. Nach dem Abgleich der Induktivität muss für jeden Kanal, in dem der VCO betrieben werden soll, der Modulationshub gemessen werden. Diese Messwerte können in einem Basisband-IC (Integrated Circuit, integrierter Schaltkreis) gespeichert und in einem Sendebetrieb vor jedem Kanalwechsel, beispielsweise über einen Datenbus, dem Hochfrequenz-IC übermittelt werden. Somit ist zusätzlicher Speicher erforderlich und weiterhin das zusätzliche Senden von Informationen vor jedem Kanalwechsel. Zudem ist eine einmalige Messung des Modulationshubes in den unterschiedlichen Kanälen erforderlich. Deshalb ist es wünschenswert, einen abgleichfreien VCO mit konstantem Modulationshub benutzen zu können, der nur eine einzige Messung des Modulationshubes erforderlich macht.

In dem Dokument DE 42 41 241 A1 ist ein spannungsgesteuerter Oszillator, der für Frequenzmodulation ausgelegt ist, angegeben. Zum Erzielen eines konstanten Frequenzhubes ist eine Koppelinduktivität vorgesehen, welche den Abstimmeingang mit einer Modulationskapazität koppelt. Derartige Induktivitäten haben jedoch nachteilhafterweise einen großen Flächenbedarf.

Der Oberbegriff des Anspruchs 1 ist aus GB 2 338 128 A bekannt In GB 2 338 128 A wird ein spannungsgesteuerter Oszillator beschrieben, bei dem an eine zusätzliche Varaktordiode eine variable Bias-Spannung angelegt wird, so dass die Änderung des Modulationshubs aufgrund der Frequenzänderung des Oszillators kompensiert wird. Die Höhe der Bias-Spannung wird über einen Mikroprozessor bestimmt.

Aufgabe der vorliegenden Erfindung ist, einen spannungsgesteuerten Oszillator anzugeben, der ohne aufwendigen Abgleich und ohne eine aufwendige Mikroprozessorsteuerung über einen großen Abstimmbereich hinweg einen geforderten Modulationshub einhält.

Erfindungsgemäß wird die Aufgabe mit einem spannungsgesteuerten Oszillator zur Frequenzmodulation gelöst, aufweisend
- einen Oszillatorkern mit zumindest einem abstimmbaren, frequenzbestimmenden Resonanzkreis-Bauelement, das mit einem Anschluss zur Zuführung einer Steuerspannung verbunden ist,
- einem frequenzbestimmenden Modulator-Bauelement, das mit einem Anschluss zur Zuführung eines Modulationssignales verbunden ist,
- wobei das Modulator-Bauelement mit dem Anschluss zur Zuführung der Steuerspannung gekoppelt ist, und mit
- einem mit dem Oszillatorkern gekoppelten Ausgangsanschluss zum Abgriff eines in Abhängigkeit vom Modulationssignal frequenzmodulierten Ausgangssignals, welches eine in Abhängigkeit von der Steuerspannung abgestimmte Trägerfrequenz hat,
- wobei das Modulator-Bauelement eine erste
spannungsgesteuerte Kapazität umfasst, die zu ihrer Steuerung mit dem Anschluss zur Zuführung der Steuerspannung verbunden ist, so dass das Modulator-Bauelement und das zumindest eine abstimmbare, frequenzbestimmende Resonanzkreis-Bauelement über den Anschluss zur Zuführung der Steuerspannung (A) steuerbar sind, und
- wobei das Modulator-Bauelement eine zweite spannungsgesteuerte Kapazität umfasst, welche parallel zur ersten spannungsgesteuerten Kapazität geschaltet und mit einem Anschluss zur Zuführung einer Vorspannung gekoppelt ist.

Die Kopplung des Modulator-Bauelements mit dem Anschluss zur Zuführung der Steuerspannung kann dabei in einfacher Weise so ausgeführt sein, dass die Abhängigkeit des Modulationshubes von der mit dem Resonanzkreis-Bauelement eingestellten Frequenz des VCO kompensiert ist.

Modulator-Bauelement und Resonator-Bauelement können gemeinsam in einem Resonator des Oszillators integriert sein.

Der Oszillatorkern kann einen Resonator aufweisen, der beispielsweise als LC-Oszillator oder als RC-Oszillator ausgeführt sein kann.

Das frequenzbestimmende Resonanzkreis-Bauelement kann beispielsweise bei LC-Oszillatoren die Induktivität oder die Kapazität des Resonators und bei RC-Oszillatoren der Widerstand oder die Kapazität des Oszillators sein.

Bei LC-Oszillatoren kann beispielsweise die Kapazität als Varaktor ausgeführt sein, üblicherweise als Kapazitätsdiode mit einer Sperrschichtkapazität, welche von der angelegten Spannung abhängt.

Während mit dem Resonanzkreis-Bauelement eine sehr starke Abweichung der Oszillatorfrequenz in Abhängigkeit von Abweichungen einer angelegten Steuerspannung erzielbar ist, werden mit dem Modulator-Bauelement nur verhältnismäßig geringe Frequenzabweichungen realisiert, welche üblicherweise um Größenordnungen kleiner sind als die vom Resonanzkreis-Bauelement verursachten. Demnach ist das Resonanzkreis-Bauelement in einem großen Bereich abstimmbar, während das Modulator-Bauelement in einem sehr kleinen Bereich abstimmbar ist. Beispielsweise kann mit dem Resonanzkreis-Bauelement eine Frequenzabstimmung von 2,2 bis 2,8 GHz erzielbar sein, während der mit dem frequenzbestimmenden Modulator-Bauelement erzielbare Modulationshub beispielsweise bei 160 KHz liegen kann. Durch die Kopplung von Anschluß zur Zuführung der Steuerspannung mit dem Modulator-Bauelement ist es möglich, den Modulationshub über den großen Frequenzbereich des VCO hinweg konstant zu halten. Der Modulationshub ist demnach unabhängig von der eingestellten Schwingfrequenz des Resonators.

Das beschriebene Prinzip kann in digitaler oder in analoger Schaltungstechnik realisiert sein.

Das Modulator-Bauelement kann unmittelbar mit dem Anschluß zur Zuführung der Steuerspannung verbunden sein.

Gemäß der vorliegenden Erfindung umfaßt das Modulator-Bauelement eine erste spannungsgesteuerte Kapazität, die zu ihrer Steuerung mit dem Anschluß zur Zuführung der Steuerspannung verbunden ist. Die spannungsgesteuerte Kapazität kann beispielsweise ein Varaktor, insbesondere eine Kapazitätsdiode mit einer Sperrschichtkapazität sein, welche steuerbar ausgeführt ist.

Weiterhin umfaßt das Modulator-Bauelement eine zweite spannungsgesteuerte Kapazität, welche parallel zur ersten spannungsgesteuerten Kapazität geschaltet und mit einem Anschluß zur Zuführung einer Vorspannung gekoppelt ist.

Das Vorspannen beispielsweise einer Kapazitätsdiode in Sperrichtung verhindert ein Durchbrechen derselben.

In einer bevorzugten Ausführungsform der vorliegenden Erfindung ist ein Entdämpfungsverstärker vorgesehen, der mit dem Oszillatorkern gekoppelt ist und den Anschluß aufweist, an dem das Ausgangssignal des Oszillators bereitgestellt ist. Neben dem bereits beschriebenen Oszillatorkern weist ein spannungsgesteuerter Oszillator üblicherweise einen Entdämpfungsverstärker auf, welcher als aktiver Schaltungsteil ausgebildet ist und eine negative Impedanz zur Kompensation von Verlusten im Resonator bereitstellt. Am Ausgang des Entdämpfungsverstärkers ist ein Ausgangssignal ableitbar, welches eine Schwing- oder Trägerfrequenz hat, die mit der Steuerspannung einstellbar ist. Der Entdämpfungsverstärker kann beispielsweise zwei kreuzgekoppelte Transistoren umfassen. Die Kreuzkopplung kann beispielsweise kapazitiv ausgebildet sein.

Ein derartiger Oszillator ist beispielsweise in einer Phasenregelschleife (PLL, Phase Locked Loop) verwendbar.

In einer weiteren, bevorzugten Ausführungsform der vorliegenden Erfindung ist das Modulator-Bauelement über zumindest einen Koppelwiderstand mit dem Anschluß zur Zuführung des Modulationssignals verbunden. Anstelle des Koppelwiderstandes können auch andere Bauelemente zur Gleichspannungskopplung oder DC-Kopplung verwendet sein.

In einer weiteren, bevorzugten Ausführungsform der Erfindung umfaßt das Resonanzkreis-Bauelement eine dritte spannungsgesteuerte Kapazität, welche über zumindest einen weiteren Koppelwiderstand mit einem Bezugspotentialanschluß verbunden ist und die zu ihrer Steuerung mit dem Anschluß zur Zuführung der Steuerspannung verbunden ist.

In einer weiteren, vorteilhaften Ausführungsform der vorliegenden Erfindung ist der Kapazitätswert der dritten spannungsgesteuerten Kapazität beziehungsweise des Resonanzkreis-Bauelementes um einen Faktor größer als der Kapazitätswert des Modulator-Bauelementes, welcher 10 oder mehr beträgt. Der Kapazitätswert des Modulator-Bauelements kann sich dabei aus einer Parallelschaltung mehrerer Varaktoren zusammensetzen.

In einer weiteren, vorteilhaften Ausführungsform der vorliegenden Erfindung sind erste Koppelkapazitäten vorgesehen zur Kopplung von Resonanzkreis-Bauelement mit zumindest einer Induktivität und zweite Koppelkapazitäten zur Kopplung von Modulator-Bauelement mit der zumindest einen Induktivität. Die Koppelkapazitäten können neben der beschriebenen Kopplung zugleich eine Kopplung des Oszillatorkerns mit dem Entdämpfungsverstärker sowie mit einem Versorgungspotentialanschluß realisieren.

In einer weiteren, bevorzugten Ausführungsform der Erfindung ist der Kapazitätswert der zweiten Koppelkapazitäten um einen Faktor kleiner als der der ersten Koppelkapazitäten, welcher 10 oder mehr beträgt.

Die Tatsache, daß das Resonanzkreis-Bauelement sowie seine Koppelkapazitäten einen Kapazitätswert haben, der groß ist gegen den Kapazitätswert des Modulator-Bauelementes sowie dessen Koppelkapazitäten, bewirkt, daß mit der Steuerspannung eine verhältnismäßig große Frequenzabweichung erzielbar ist, während mit dem Modulationssignal lediglich eine verhältnismäßig kleine Frequenzabweichung, welche dem Modulationshub entspricht, erzielbar ist.

In einer weiteren, bevorzugten Ausführungsform der vorliegenden Erfindung weist der Oszillator einen symmetrischen Schaltungsaufbau auf. Der symmetrische Schaltungsaufbau ermöglicht insbesondere eine hohe Störfestigkeit.

Weitere Einzelheiten der vorliegenden Erfindung sind Gegenstand der Unteransprüche.

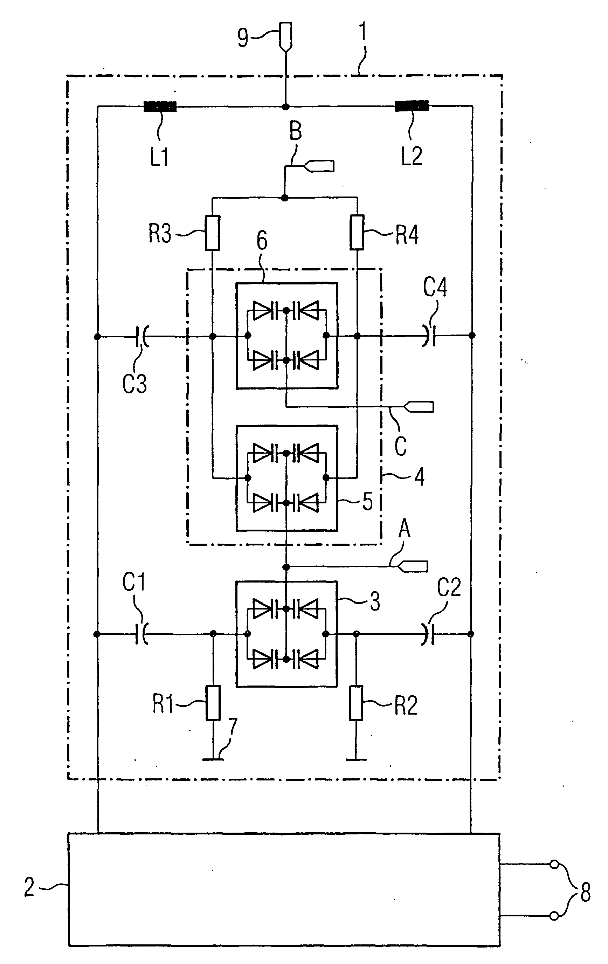

Die Erfindung wird nachfolgend anhand eines Ausführungsbeispiels an einer Zeichnung näher erläutert. Es zeigt:
die Figur ein Ausführungsbeispiel des erfindungsgemäßen Oszillators anhand eines vereinfachten Schaltbildes.

Die Figur zeigt einen spannungsgesteuerten Oszillator mit einem Oszillatorkern 1 und einem daran angeschlossenen Entdämpfungsverstärker 2, wobei letzterer lediglich symbolisch eingezeichnet ist.

Der Oszillatorkern 1 weist einen symmetrischen Schaltungsaufbau auf. Am Entdämpfungsverstärker 2 ist ein Ausgangsanschluß 8 vorgesehen, an dem ein mit einer Steuerspannung A frequenzmäßig abstimmbares Ausgangssignal bereitsteht. Weiterhin ist dem Oszillatorkern ein Modulationssignal B zuführbar, welches dem Oszillator über einen Übertragungskanal die zu übertragenden Informationen, welche digital codiert sind, zuleiten kann.

Der Oszillatorkern 1 ist als LC-Oszillator ausgebildet. Dabei sind feste Induktivitäten L1, L2 vorgesehen, welche jeweils mit einem Anschluß mit einem Versorgungsspannungsanschluß 9 verbunden sind. Mit ihren freien Anschlüssen sind die Induktivitäten L1, L2 mit Koppelkapazitäten C1, C2, C3, C4 sowie mit dem Entdämpfungsverstärker 2 verbunden.

Das Resonanzkreis-Bauelement 3, dem die resonanzkreisfrequenzbestimmende Steuerspannung A an einem Eingang zuführbar ist, ist mit je einer der beiden Koppelkapazitäten C1, C2 sowie mit je einem Widerstand R1, R2 verbunden, wobei letztere an einen Bezugspotentialanschluß 7 angeschlossen sind. Das Resonanzkreis-Bauelement 3 umfaßt mehrere Kapazitätsdioden, welche kathodenseitig miteinander und mit dem Anschluß zur Zuführung der Steuerspannung A verbunden und welche anodenseitig mit den Koppelkapazitäten C1, C2 und den Koppelwiderständen R1, R2 verbunden sind.

Das Modulator-Bauelement 4 umfaßt zwei parallel geschaltete spannungsgesteuerte Kapazitäten 5, 6, welche jeweils aus kathodenseitig miteinander verbunden Kapazitätsdioden gebildet sind. Der ersten spannungsgesteuerten Kapazität 5 ist an einem den Kapazitätswert steuernden Eingang die Steuerspannung A zuführbar, während der zweiten spannungsgesteuerten Kapazität 6 an einem den Kapazitätswert steuernden Eingang eine Vorspannung C zuführbar ist. Die erste spannungsgesteuerte Kapazität 5 umfaßt Kapazitätsdioden, welche kathodenseitig miteinander und mit dem Anschluß zur Zuführung der Steuerspannung A und anodenseitig mit je einer Koppelkapazität C3, C4 verbunden sind.

Folglich sind die Steuereingänge von erster spannungsgesteuerter Kapazität 5 und Resonanzkreis-Bauelement 3 unmittelbar miteinander verbunden.

Die zweite spannungsgesteuerte Kapazität 6 umfaßt Kapazitätsdioden, welche kathodenseitig miteinander und mit dem Anschluß zur Zuführung der Vorspannung C verbunden sind und anodenseitig mit den Koppelkapazitäten C3, C4 verbunden sind. Demnach sind erste und zweite spannungsgesteuerte Kapazität parallel geschaltet. Der bei dieser Parallelschaltung anodenseitig an den Kapazitätsdioden gebildete symmetrische Schaltungsknoten ist neben den Koppelkapazitäten C3, C4 mit Koppelwiderständen R3, R4 verbunden, welche mit ihrem freien Ende an den Anschluß zur Zuführung des Modulationssignals B angeschlossen sind.

Die Kapazitätswerte der ersten Koppelkapazitäten C1, C2 sind groß gegen die Kapazitätswerte der zweiten Koppelkapazitäten C3, C4. Weiterhin sind Varaktor-Dioden, welche von einer dritten spannungsgesteuerten Kapazität im Resonanzkreis-Bauelement 3 umfaßt sind, mit ihren Kapazitätswerten groß gegen diejenigen Kapazitätswerte, welche sich aus der Parallelschaltung der ersten und zweiten spannungsgesteuerten Kapazitäten 5, 6 ergeben. Die Kapazitätswerte unterscheiden sich dabei jeweils mindestens um einen Faktor 10 voneinander.

Mit der Steuerspannung A ist der Resonator im Oszillatorkern 1 in einem Frequenzbereich von 2,2 - 2,8 GHz abstimmbar. Der mit dem Modulationssignal B erzielbare Modulationshub beträgt 160 KHz.

Dem Modulator-Bauelement 4 ist jedoch gemäß dem vorgeschlagenen Prinzip auch die Steuerspannung A zu Kompensationszwecken zuführbar, derart, daß der Modulationshub von 160 KHz über den gesamten, abstimmbaren Frequenzbereich des Oszillators hinweg gleich bleibt. Wenn beispielsweise die Steuerspannung A ansteigt, beispielsweise von 1 auf 2 Volt, so nimmt die Kapazität des Resonanzkreis-Bauelements 3 ab. Denn über die Widerstände R1, R2 ist der Varaktor 3 anodenseitig und gleichspannungsmäßig mit Bezugspotentialanschluß 7 gekoppelt. Zugleich wird die erste spannungsgesteuerte Kapazität 5, insbesondere deren Kapazitätsdioden, stärker gesperrt. Somit ist sichergestellt, daß mit dem Modulationssignal B eine verhältnismäßig kleinere Kapazitätsänderung im Modulator-Bauelement 4 bewirkt ist. Beim vorliegenden Ausführungsbeispiel ist die steuernde Spannung des Modulationssignals B frei von einem Gleichspannungsanteil und bewegt sich in einem Bereich von 0 bis 20 mV. Die Vorspannung C beträgt +1 V. Damit ist sichergestellt, daß die Kapazitätsdioden in Sperrichtung betrieben werden.

Das beschriebene Prinzip, nämlich die ohnehin bekannte Abstimmspannung A heranzuziehen, um über einen großen abstimmbaren Frequenzbereich eines VCO hinweg stets einen konstanten Modulationshub zu erzielen, kann anstelle der gezeigten, analogen Schaltungsrealisierung auch in einer digitalen Schaltung realisiert sein. Dabei könnte beispielsweise die Steuerspannung A gemessen und digitalisiert werden und zur Umprogrammierung des Modulationssignals B herangezogen werden, so, daß über den gesamten, abstimmbaren Frequenzbereich des Oszillators hinweg der Modulationshub stets konstant ist.

Mit dem beschriebenen Prinzip können spannungsgesteuerte Oszillatoren zur Frequenzmodulation insbesonders auch dann über einen großen Frequenzbereich hinweg einen konstanten Modulationshub haben, wenn die frequenzbestimmenden Bauelement des Oszillators toleranzbehaftet sind.

Mit der beschriebenen Schaltung ist bei großen Steuerspannungen A mit dem Modulationssignal B eine geringere Kapazitätsänderung der wirksamen Kapazität im Resonator bewirkt.

Die Modulationskapazität, das heißt die Kapazität des Modulator-Bauelements 4, ist demnach variabel und hängt von der jeweils gültigen Steuerspannung A ab. Dies wird dadurch erreicht, daß ein Teil der Kapazitäten im Modulator-Bauelement 4 nicht auf ein festes Potential gelegt wird, sondern daß die spannungsgesteuerte Kapazität 5 mit der Steuerspannung A vorgespannt wird.

### Bezugszeichenliste

- 1: Oszillatorkern
- 2: Entdämpfungsverstärker
- 3: Resonanzkreis-Bauelement
- 4: Modulator-Bauelement
- 5: Spannungsgesteuerte Kapazität
- 6: Spannungsgesteuerte Kapazität
- 7: Bezugspotentialanschluß
- 8: Ausgangsanschluß
- 9: Versorgungsspannungsanschluß
- A: Steuerspannung
- B: Modulationssignal
- C: Vorspannung
- C1: Kapazität
- C2: Kapazität
- C3: Kapazität
- C4: Kapazität
- L1: Induktivität
- L2: Induktivität
- R1: Widerstand
- R2: Widerstand
- R3: Widerstand
- R4: Widerstand

## Patentansprüche

1. Spannungsgesteuerter Oszillator zur Frequenzmodulation, aufweisend einen Oszillatorkern (1), mit
- zumindest einem abstimmbaren, frequenzbestimmenden Resonanzkreis-Bauelement (3), das mit einem Anschluss zur Zuführung einer Steuerspannung (A) zur Frequenzabstimmung verbunden ist,
- einem frequenzbestimmenden Modulator-Bauelement (4), das mit einem Anschluss zur Zuführung eines Modulationssignales (B) verbunden ist,
- wobei der Anschluss zur Zuführung der Steuerspannung (A) mit dem Modulator-Bauelement (4) gekoppelt ist, und
- einem mit dem Oszillatorkern (1) gekoppelten Ausgangsanschluss (8) zum Abgriff eines in Abhängigkeit vom Modulationssignal (B) frequenzmodulierten Ausgangssignals mit einer in Abhängigkeit von der Steuerspannung (A) abgestimmten Trägerfrequenz,
- **dadurch gekennzeichnet, dass** das Modulator-Bauelement (4) eine erste spannungsgesteuerte Kapazität (5) umfasst, die zu ihrer Steuerung mit dem Anschluss zur Zuführung der Steuerspannung (A) verbunden ist, so dass das Modulator-Bauelement und das zumindest eine abstimmbare, frequenzbestimmende Resonanzkreis-Bauelement über den Anschluss zur Zuführung der Steuerspannung (A) steuerbar sind, und
- wobei das Modulator-Bauelement (4) eine zweite spannungsgesteuerte Kapazität (6) umfasst, welche parallel zur ersten spannungsgesteuerten Kapazität (5) geschaltet und mit einem Anschluss zur Zuführung einer Vorspannung (C) gekoppelt ist.

2. Oszillator nach Anspruch 1,
**dadurch gekennzeichnet,**
**dass** ein Entdämpfungsverstärker (2) vorgesehen ist, der mit dem Oszillatorkern (1) gekoppelt ist und den Ausgangsanschluss (8) aufweist, an dem das Ausgangssignal des Oszillators bereitgestellt ist.

3. Oszillator nach Anspruch 1 oder 2,
**dadurch gekennzeichnet,**
**dass** das Modulator-Bauelement (4) über zumindest einen Koppelwiderstand (R3) mit dem Anschluss zur Zuführung des Modulationssignals (B) verbunden ist.

4. Oszillator nach einem der Ansprüche 1 bis 3,
**dadurch gekennzeichnet,**
**dass** das Resonanzkreis-Bauelement (3) eine dritte spannungsgesteuerte Kapazität (3) umfasst, welche über zumindest einen weiteren Koppelwiderstand (R1) mit einem Bezugspotentialanschluss (7) verbunden ist und die zu ihrer Steuerung mit dem Anschluss zur Zuführung der Steuerspannung (A) verbunden ist.

5. Oszillator nach Anspruch 4,
**dadurch gekennzeichnet,**
**dass** der Kapazitätswert der dritten spannungsgesteuerten Kapazität (3) um einen Faktor grösser ist als der Kapazitätswert des Modulator-Bauelements (4), welcher 10 oder mehr beträgt.

6. Oszillator nach einem der Ansprüche 1 bis 5,
**dadurch gekennzeichnet,**
**dass** erste Koppelkapazitäten (C1, C2) vorgesehen sind zur Kopplung von Resonanzkreis-Bauelement (3) mit zumindest einer Induktivität (L1), und zweite Koppelkapazitäten (C3, C4) zur Kopplung von Modulator-Bauelement (4) mit der zumindest einen Induktivität (L1).

7. Oszillator nach Anspruch 6,
**dadurch gekennzeichnet,**
**dass** der Kapazitätswert der zweiten Koppelkapazitäten (C3, C4) um einen Faktor kleiner ist als der Kapazitätswert der ersten Koppelkapazitäten (C1, C2), der 10 oder mehr beträgt.

8. Oszillator nach einem der Ansprüche 1 bis 7,
**dadurch gekennzeichnet,**
**dass** der Oszillator einen symmetrischen Schaltungsaufbau aufweist.

## Claims

1. A voltage-controlled oscillator for frequency modulation, comprising an oscillator core (1) including:
- at least one tunable, frequency-determining resonance circuit component (3), which is connected to a terminal for supplying a control voltage (A) for frequency tuning,
- a frequency-determining modulator component (4), which is connected to a terminal for supplying a modulation signal (B),
- wherein the terminal for supplying the control voltage (A) is coupled to the modulator component (4), and
- an output terminal (8) coupled to said oscillator core (1) said output terminal providing an output signal, the output signal being frequency modulated in dependence on the modulation signal (B) by a carrier frequency tuned in dependence on the control voltage (A),
**characterized in that**
- the modulator component (4) comprises a first voltage controlled capacitance (5), which is connected to the terminal for supplying the control voltage (A) in order to be controlled such that the modulator component and the at least one tunable, frequency-determining resonance circuit component is controllable using the terminal for supplying the control voltage (A), and
- wherein the modulator component (4) comprises a second voltage-controlled capacitance (6), which is switched in parallel to the first voltage-controlled capacitance (5) and is coupled to a terminal for supplying a bias voltage (C).

2. Oscillator according to claim 1,
**characterized in that**
a deattentuation amplifier (2) is provided, which is coupled to said oscillator core (1), said deatenuation amplifier including said output terminal (8), providing the output signal of the oscillator.

3. Oscillator according to claim 1 or 2,
**characterized in that**
the modulator component (4) is connected to the terminal for supplying the modulation signal (B) via at least one coupling resistor (R3).

4. Oscillator according to one of claims 1 to 3,
**chracterized in that**
the resonance circuit component (3) comprises a voltage-controlled capacitance (3), which is connected to at least one reference potential terminal (7) via at least one additional coupling resistor (R1) and which is connected to the terminal for supplying the control voltage (A) in order to be controlled.

5. Oscillator according to claim 4,
**characterized in that**
the capacitance value of the third voltage-controlled capacitance (3) is greater than the capacitance value of the modulator component (4) by a factor of at least 10.

6. Oscillator according to one of the claims 1 to 5,
**characterized in that**
first coupling capacitances (C1, C2) are provided for coupling the resonance circuit component (3) to at least one inductance (L1), and second coupling capacitances (C3, C4) for coupling the modulator component (4) to the at least one inductance (L1).

7. Oscillator according to claim 6,
**characterized in that**
the capacitance value of the second coupling capacitances (C3, C4) is smaller than the capacitance value of the first coupling capacitances (C1, C2) by a factor of at least 10.

8. Oscillator according to one of the claims 1 to 7,
**characterized in that**
the oscillator is configured as a symmetric circuit configuration.

## Revendications

1. Oscillateur commandé en tension pour la modulation de fréquence, comprenant un noyau (1) d'oscillateur ayant
- au moins un composant (3) à circuit de résonance, qui peut être accordé, qui détermine la fréquence et qui, pour l'accord de fréquence, est relié à une borne d'application d'une tension (A) de commande,
- un composant (4) formant modulateur, qui détermine la fréquence et qui est relié à une borne pour l'application d'un signal (B) de modulation,
- dans lequel la borne d'application de la tension (A) de commande est couplée au composant (4) formant modulateur, et
- une borne (6) de sortie, qui est couplée au noyau (1) d'oscillateur et qui est destinée à la prise d'un signal de sortie, qui est modulé en fréquence en fonction du signal (B) de modulation et qui a une fréquence porteuse accordée en fonction de la tension (A) de commande,
- **caractérisé en ce que**
- le composant (4) formant modulateur comprend une première capacité (5) qui est commandée en tension et qui est reliée à sa commande par la borne d'application de la tension (A) de commande de manière à ce que le composant formant modulateur et le au moins un composant à circuit de résonance, qui peut être accordé et qui détermine la fréquence, puissent être commandés par la borne pour l'application de la tension (A) de commande, et
- dans lequel le composant (4) formant modulateur comprend une deuxième capacité (6) qui est commandée en tension, qui est montée en parallèle à la première capacité (5) commandée en tension et qui est couplée à une borne d'application d'une tension ( C ) de polarisation.

2. Oscillateur suivant la revendication 1,
**caractérisé**
**en ce qu'**il est prévu un amplificateur (2) de compensation de l'amortissement, qui est couplé au noyau (1) de l'oscillateur et qui comporte la borne de sortie où le signal de sortie de l'oscillateur est disponible.

3. Oscillateur suivant la revendication 1 ou 2,
**caractérisé**
**en ce que** le composant (4) formant modulateur est relié à la borne d'application du signal (B) de modulation par au moins une résistance (R3) de couplage.

4. Oscillateur suivant l'une des revendications 1 à 3,
**caractérisé en ce que** le composant (3) à circuit de résonance comprend une troisième capacité (3) qui est commandée en tension, qui est reliée à une borne (7) de potentiel de référence par au moins une autre résistance (R1) de couplage et qui est reliée à sa commande par la borne d'application de la tension (A) de commande.

5. Oscillateur suivant la revendication 4,
**caractérisé**
**en ce que** la valeur de la troisième capacité (3) commandée en tension est plus grande que la valeur de la capacité du composant (4) formant modulateur d'un facteur qui est supérieur ou égal à 10.

6. Oscillateur suivant l'une des revendications 1 à 5,
**caractérisé**
**en ce qu'**il est prévu des premières capacités (C1, C2) de couplage pour le couplage du composant (3) à circuit de résonance à au moins une inductance (L1) et des deuxièmes capacités (C3, C4) de couplage pour le couplage du composant (4) formant modulateur à la au moins une inductance (L1).

7. Oscillateur suivant la revendication 6,
**caractérisé**
**en ce que** la valeur des deuxièmes capacités (C3, C4) de couplage est plus petite que la valeur des premières capacités (C1, C2) de couplage d'un facteur qui est supérieur ou égale à 10.

8. Oscillateur suivant l'une des revendications 1 à 7,
**caractérisé**
**en ce que** l'oscillateur a une structure de circuit symétrique.
